# EUROPEAN PATENT APPLICATION

(11) **EP 2 130 672 A1**
(43) Date of publication of application: **09.12.2009**
(21) Application number: 08739011.8
(22) Date of filing: 27.03.2008
(51) Int. Cl.: B32B 17/06, G09F 9/30

(54) **FLEXIBLE SUBSTRATE**

(30) Priority: 28.03.2007 JP 2007083666
(71) Applicant: Nippon Telegraph and Telephone Corporation, Chiyoda-ku Tokyo 100-8116 (JP)
(72) Inventor: YANO, Hiroyuki, Uji-shi Kyoto 611-0011 (JP); NOGI, Masaya, Kyoto-shi Kyoto 606-8501 (JP); ABE, Kentarou, Kyoto-shi Kyoto 606-8501 (JP); IFUKU, Shinsuke, Kyoto-shi Kyoto 606-8501 (JP); KURIHARA, Takashi, Musashino-shi Tokyo 180-8585 (JP)
(74) Representative: Ilgart, Jean-Christophe
(86) International application number: PCT/JP2008/055882
(87) International publication number: WO 2008/117848

(57) **Abstract**

A flexible substrate 1 of the present invention is formed of a thin glass sheet 10 having a thickness of 50 µm or less and a composite material sheet 20 having a thickness of 100 µm or less which are laminated together, the composite material sheet 20 being formed of a composite material of an aggregation of cellulose nanofiber and amorphous synthetic resin.

## Description

### TECHNICAL FIELD

The present invention relates to a flexible substrate used, for example, as a flexible display substrate.
This application claims priority of Japanese Patent Application No. 2007-83666 filed March 28, 2007, which is incorporated herein by reference in its entirety.

### BACKGROUND ART

Recently, flexible displays have been developed in which light emitting devices, such as LEDs, are provided on a flexible substrate having flexibility.

Examples of the flexible substrate used in a flexible display include a glass substrate, a silicon substrate, a stainless steel substrate and a plastic substrate.
Japanese Unexamined Patent Application, First Publication No. 2005-60680 discloses that a composite material sheet wherein matrix resin is reinforced by cellulose fibers can be used as a substrate.
However, the glass and silicon substrates crack easily upon bending; the stainless steel substrate is heavyweight; and the plastic substrate has poor heat resistance, chemical resistance and gas barrier properties. These substrates are therefore not suitable as a flexible substrate.
The composite material sheet proposed in Japanese Unexamined Patent Application, First Publication No. 2005-60680 has poor surface smoothness and gas barrier properties and is therefore not suitable as a substrate.

### DISCLOSURE OF THE INVENTION

### PROBLEMS TO BE SOLVED BY THE INVENTION

In view of the foregoing, it is an object of the present invention to provide a flexible substrate that is lightweight and has improved bending strength and gas barrier properties, and has a smooth surface.

### MEANS FOR SOLVING THE PROBLEMS

A flexible substrate of the present invention is formed of a thin glass sheet having a thickness of 50 µm or less and a composite material sheet having a thickness of 100 µm or less which are laminated together, the composite material sheet being formed of a composite material of an aggregation of cellulose nanofiber and amorphous synthetic resin.
In the flexible substrate of the present invention, the cellulose nanofiber may be a plant-based cellulose.
In the flexible substrate of the present invention, the cellulose nanofiber may be a bacterial cellulose.
In the flexible substrate of the present invention, the amorphous synthetic resin may be a low-elasticity epoxy resin having a Young's modulus of 0.1 GPa or less.
In the flexible substrate of the present invention, the amorphous synthetic resin may be a low-elasticity acrylic resin having a Young's modulus of 0.1 GPa or less.
In the flexible substrate of the present invention, a thickness of the thin glass sheet may be 20 to 30 µm.

### EFFECTS OF THE INVENTION

The flexible substrate according to the present invention is lightweight, and has improved bending strength and gas barrier properties and has a smooth surface. This flexible substrate is suitable for a flexible device, such as a flexible display.

### BRIEF DESCRIPTION OF THE DRAWINGS

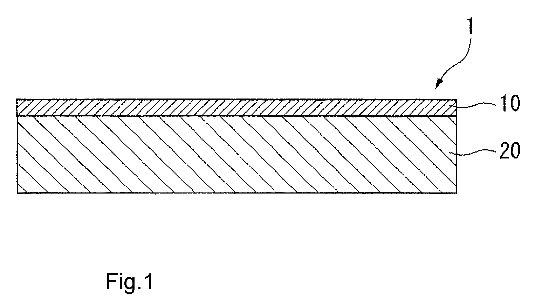

Fig. 1 is a cross-sectional view of an embodiment of a flexible substrate according to the present invention.

### DESCRIPTION OF SYMBOLS

- 1: Flexible substrate
- 10: Thin glass sheet
- 20: Composite material sheet

### BEST MODE FOR CARRYING OUT THE INVENTION

Hereinafter, an embodiment of a flexible substrate according to the present invention will be described.
Fig. 1 illustrates a flexible substrate according to the present embodiment. A flexible substrate 1 includes a thin glass sheet 10 and a composite material sheet 20 which are laminated together.

### (Thin Glass Sheet)

The thin glass sheet 10 is a glass plate having a thickness of 50 µm or less. Glass sheets having a thickness of more than 50 µm have insufficient flexibility and thus are not suitable for the flexible substrate 1. The preferred thickness of the thin glass sheet 10 is 20 to 30 µm. The thin glass sheet 10 having a thickness of 20 µm or more can be easily fabricated. The thin glass sheet 10 having a thickness of 30 µm or less has greater flexibility.

The thin glass sheet 10 may be made of, for example, borosilicate glass (having 2 to 8 mass% ofNa), non-alkali glass and quartz glass.

### (Composite Material Sheet)

The composite material sheet 20 is a composite sheet formed of an aggregation of cellulose nanofiber and amorphous synthetic resin. In particular, the composite material sheet 20 includes an aggregation of the cellulose nanofiber buried into a layer of the amorphous synthetic resin. Upon this constitution, the amorphous synthetic resin is reinforced by the aggregation of the cellulose nanofiber.

### [Aggregation of Cellulose Nanofiber]

An average fiber diameter of the cellulose nanofiber is 4 to 200 nm, preferably 4 to 100 nm and more preferably 4 to 60 nm. Cellulose nanofiber having an average fiber diameter of greater than 200 nm has a wavelength approximate to a wavelength of the visible light. The visible light may often be reflected at an interface of the cellulose nanofiber and the amorphous synthetic resin, causing the cellulose nanofiber to be less transparent. Cellulose nanofiber having an average fiber diameter of less than 4 nm is difficult to manufacture.

The cellulose nanofiber used in the present invention may have a fiber diameter out of the range of 4 to 200 nm so long as the average fiber diameter of the cellulose nanofiber is in the range of 4 to 200 nm, but the ratio thereof may preferably be not more than 30 mass%.
From the viewpoint of availability of desired physical properties, however, all the cellulose nanofiber preferably have the fiber diameter of 200 nm or less, more preferably 100 nm or less and most preferably 60 nm or less.

The length of the cellulose nanofiber is not particularly limited but may preferably be 100 nm or more on the average length. If the average length of the cellulose nanofiber is shorter than 100 nm, the reinforcing effect of the cellulose nanofiber is small and thus the strength of the composite material sheet 20 may be insufficient. The cellulose nanofiber may include nanofiber having a fiber length shorter than 100 nm, but the ratio thereof may preferably be not more than 30 mass%.

A degree of crystallinity of the cellulose nanofiber is preferably 40% or more, more preferably 60% or more, and most preferably 70% or more. The cellulose nanofiber having a degree of crystallinity of 40% or more may provide both sufficient strength and low thermal expansion.
The degree of crystallinity of the cellulose nanofiber can be obtained as an area ratio (percentage) of the crystal part with respect to an entire area of the X-ray diffraction diagram determined by X-ray diffraction measurement.

Among the cellulose nanofiber, bacterial cellulose produced by bacteria and plant-based cellulose derived from plants are preferably used because of their ability to increase the bending strength.

### <Bacterial Cellulose>

Bacterial cellulose obtained by subjecting a bacteria product to alkali treatment so as to dissolve and remove the bacteria is preferably used without disaggregation process.

Examples of the bacteria that may produce cellulose include acetic acid bacteria and soil bacteria. Examples of the acetic acid bacteria include, but are not limited to, Acetobacters, such as Acetobacter aceti, Acetobacter subsp. and Acetobacter xylinum.

Cellulose is produced from these bacteria while the bacteria are cultivated. The product obtained from the bacteria includes bacteria and cellulose fibers (i.e., bacterial cellulose) which are produced from and are linked to the bacteria. Aqueous bacterial cellulose including no bacteria can be obtained by taking the product out of a cultivation medium, washing or subjecting to alkali treatment to remove bacteria. Then, by removing moisture from the aqueous bacterial cellulose, the bacterial cellulose can be obtained.

Examples of the cultivation medium include an agar-shaped solid cultivation medium and a liquid cultivation medium (i.e., cultivation liquid).
Examples of the cultivation liquid include a cultivation liquid which contains 7 mass% of coconut milk (having 0.7 mass% of total nitrogen content and 28 mass% of lipid content) and 8 mass% of sucrose, with the pH adjusted to 3.0 by acetic acid, and an aqueous solution (Schramm-Hestrin medium) which contains 2 mass% of glucohol, 0.5 mass% of Bacto yeast extract, 0.5 mass% of Bacto peptone, 0.27 mass% of disodium hydrogenphosphate, 0.115 mass% of citrate and 0.1 mass% of magnesium sulfate heptahydrate, with the pH adjusted to 5.0 by hydrochloric acid.

Cultivation may be conducted in the following manner. Acetic acid bacteria, such as Acetobacter xylinum FF-88, is inoculated in a coconut milk cultivation liquid. The FF-88, for example, is left for static cultivation at 30 °C for five days and a primary cultivation liquid is obtained. After removing a gel part of the obtained primary cultivation liquid, a liquid part is added to a cultivation liquid similar to that described above in an amount of 5 mass%. The liquid is left for static cultivation at 30 °C for ten days and a secondary cultivation liquid is obtained. The secondary cultivation liquid contains about 1 mass% of cellulose fiber.

Alternatively, a solution (i.e., a Schramm-Hestrin cultivation liquid) containing 2 mass% of glucose, 0.5 mass% of Bacto yeast extract, 0.5 mass% of bacto peptone, 0.27 mass% of disodium hydrogenphosphate, 0.115 mass% of citrate and 0.1 mass% of magnesium sulfate heptahydrate may be used as a cultivation liquid, with the pH adjusted to 5.0 by hydrochloric acid. In this case, the Schramm-Hestrin cultivation liquid is added to strains of freeze-dried acetic acid bacteria and the obtained liquid is left for static cultivation (at 25 to 30 °C) for a week. The bacterial cellulose is produced on a cultivation liquid surface. A small amount of cultivation liquid is taken from the strains at thickened areas of the produced bacterial cellulose, and is added to a new cultivation liquid. The cultivation liquid is put into a large incubator and then subject to static cultivation for 7 to 30 days at 25 to 30 °C. This process of adding a part of the existing cultivation liquid to a new cultivation liquid and leaving the cultivation liquid for static cultivation for about 7 to 30 days is repeated and the bacterial cellulose is obtained.

If any problem including difficulty in cellulose fabrication by the bacteria is found, the following procedure is conducted. On an agar medium obtained by adding agar to a cultivation liquid, a small amount of cultivation liquid cultivating bacteria is scattered and then left for about one week to produce colonies. As a result of observation of the colonies, colonies that are more likely to produce cellulose are taken out of the agar medium and are introduced into a new cultivation liquid for cultivation.

The produced bacterial cellulose is then taken out of the cultivation liquid and bacteria which remain in the bacterial cellulose are removed by, for example, washing or an alkali treatment. Examples of the alkali treatment to dissolve and remove the bacteria include adding the bacterial cellulose taken out of the cultivation liquid to an about 0.01 to 10 mass% of alkaline aqueous solution for one hour or more. The bacterial cellulose is taken out of the alkali treatment solution, washed well with water and then the alkali treatment solution is removed.

The thus-obtained aqueous bacterial cellulose (usually, bacterial cellulose having 95 to 99 mass% of a moisture content) is then subjected to moisture removal.

The process of moisture removal is not particularly limited, but may include removing a certain amount of moisture by leaving the aqueous bacterial cellulose or by cold pressing, and then completely removing the moisture by continuously leaving or hot pressing, or removing the moisture of a cold pressed aqueous bacterial cellulose by heat drying or air drying.

Leaving the aqueous bacterial cellulose to remove a certain amount of the moisture means gradually vaporizing the moisture over a long time.

The cold pressing is a process to remove moisture by applying pressure to squeeze a certain amount of moisture without heat. The pressure in the cold pressing is preferably 0.01 to 10 MPa and more preferably 0.1 to 3 MPa. If the pressure is smaller than 0.01 MPa, there is a likelihood that the amount of residual moisture becomes large and if the pressure is larger than 10 MPa, there is a possibility that the obtained bacterial cellulose may be destroyed. The temperature is not particularly limited, but may preferably be the normal temperature from the viewpoint of operability.

Leaving the aqueous bacterial cellulose to completely remove the residual moisture means drying the bacterial cellulose over a long period of time.

The hot pressing is a process to remove moisture by applying heat and pressure to the bacterial cellulose. The residual moisture can be completely removed in this process. The pressure in the hot pressing is preferably 0.01 to 10 MPa and more preferably 0.2 to 3 MPa. If the pressure is smaller than 0.01 MPa, there is a possibility that the moisture is not removed, and if the pressure is larger than 10 MPa, there is a possibility that the bacterial cellulose may be destroyed. The temperature in the hot pressing is preferably 100 to 300 °C and more preferably 110 to 200 °C. If the temperature is lower than 100 °C, removal of moisture will take a longer period of time and if the temperature is higher than 300 °C, there is a possibility that the bacterial cellulose may be decomposed.

The drying temperature in heat drying is preferably 100 to 300 °C and more preferably 110 to 200 °C. If the drying temperature is lower than 100 °C, there is a possibility that the moisture is not removed and if the drying temperature is higher than 300 °C, there is a possibility that the cellulose fiber may be decomposed.

The thus-obtained bacterial cellulose is a sheet (hereinafter referred to as a "BC sheet") having a bulk density of 1.1 to 1.3 kg/m³ and a thickness of about 40 to 60 µm depending on cultivation conditions and pressurizing and heating conditions in the subsequent moisture removal.

### <Plant-Based Cellulose>

Plant-based cellulose may be suitably obtained from wood powders. Cotton can also be used for the cellulose.
Examples of the wood powder include bamboo powder, softwood powder and hardwood powder. The hardwood powder is preferred from the viewpoint of easiness in lignin removal.
Wood powders having a major axis of 10 µm to 1 mm are preferably used. If the major axis is longer than 1 mm, fiberization may become insufficient in a mechanical fiberization process which will be described later. If the major axis is shorter than 10 µm, a cellulose crystal may be destroyed during pulverization and the degree of crystallinity may become insufficient.
The upper limit of the major axis is more preferably 500 µm or less, even more preferably 300 µm or less and most preferably 200 µm or less. The lower limit of the major axis is more preferably 30 µm or more, even more preferably 50 µm or more, and most preferably 100 µm or more.
A ratio of the major axis to the minor axis may preferably be 10 or less, more preferably 5 or less and most preferably 3 or less. The mechanical fiberization becomes difficult if the ratio of the major axis to minor axis is greater than 10.

The wood powder used as the material of the nanofiber preferably contain a moisture content of 3 to 70 mass%, more preferably 5 to 50 mass% and most preferably 10 to 40 mass%. If the moisture content is less than 3 mass%, cellulose fibers come close to one another to facilitate creation of hydrogen bonds therebetween. As a result, fiberization becomes insufficient. If the moisture content is greater than 70 mass%, the wood powder becomes soft and causes difficulty in handling and conveyance.

Examples of the process to obtain cellulose fibers from the wood powder include sequentially providing degreasing process, lignin removal process, hemicellulose removal process and mechanical fiberization process to the wood powder.

### Degreasing Process

An organic solvent may preferably be used in degreasing. Examples of the organic solvent include an ethanol benzene-mixed liquid because of its greater elution performance.

### Lignin Removal Process

The Wise method using sodium chlorite/acetic acid is preferably used in the lignin removal because of its simple operability and availability for a large number of samples.
The Wise method will be described in detail below.
A solution of 60 ml of distilled water, 0.4g of sodium chlorite and 0.08 ml of glacial acetic acid is prepared with respect to 1g of a degreasing sample. The solution is heated for one hour in a 70 to 80 °C water bath while being agitated intermittently. After one hour, 0.4g of sodium chlorite and 0.08 ml of glacial acetic acid are added to the uncooled solution. This process is repeated four or more times for the softwood powder and three or more times for the hardwood powder. The solution is then washed sequentially by using about 500 ml of cold water and about 500 ml of acetone (alternatively, ethanol or methanol). Any residual moisture, chemicals and residues are removed in this washing process and a lignin-free sample is obtained.

For the lignin removal process, a method other than the Wise method may also be employed. Examples include a method with chlorine dioxide and a method with oxygen under the presence of alkali.

### Hemicellulose Removal Process

An alkaline aqueous solution may, for example, be used to remove hemicellulose.
Examples of the alkali used in the process of the alkaline aqueous solution include sodium hydroxide and potassium hydroxide. The concentration of the aqueous solution of potassium hydroxide is preferably 3 to 10 mass% and more preferably 5 to 8 mass%. When the concentration of the aqueous solution is 10 mass% or less, dissolution of crystal of the cellulose can be prevented. When the concentration of the aqueous solution is 3 mass% or more, the hemicellulose can be completely removed.

The hemicellulose-free wood powder may preferably be collected by suction filtration and then washed. About 2 liters or more of water may be preferably used to wash 10 g of the sample.

### Mechanical Fiberization Process

Mechanical fiberization is a process to mechanically apply power to the hemicellulose-removed sample to detangle the fibers and therefore obtain nanofiber.
An apparatus used to apply mechanical force may be a grinder, a homogenizer and a refiner. From the viewpoint of easiness in producing the nanofiber, the grinder may preferably be used alone, or used in combination with the homogenizer or the refiner.

Preferably, the sample includes a moisture content of 3 mass% or more in all the processes before the mechanical fiberization. If the moisture content in the sample is too small, the cellulose fibers themselves aggregate by hydrogen bonds and the mechanical fiberization effect is impaired and the fiberization becomes insufficient.

The grinder is a stone mill grinding machine which grinds a sample placed between vertically arranged two plate-shaped grindstones. The sample is given an impact, centrifugal force and shearing force to be ground into ultrafine particles. The grinder may provide shearing, grinding, microparticulation, distribution, emulsification and fibrillation at one time.
Examples of the grinder include "Super Mass Colloider" and "Serendipiter" available from Masuko Sangyo Co., Ltd., and "Pure Fine Mill" available from Kurita Machinery MFG. Co., Ltd. "Super Mass Colloider" available from Masuko Sangyo Co., Ltd. is a ultrafine stone mill grinder having two vertically arranged nonporous grindstones. The distance between the grindstones can be controlled. The upper plate of the grindstones is fixed and the lower plate is made to rotate at a high speed. A sample placed between the grindstones is given strong compression force, shearing force and rolling friction force generated there and is gradually ground to ultrafine particles.

The distance between the grindstones is preferably 1 mm or less, more preferably 0.5 mm or less, even more preferably 0.1 mm or less and most preferably 0.05 mm or less.
The diameter of the grindstone is preferably 5 cm or more, and more preferably 10 cm or more.
The rotational speed is preferably 500 rpm or more, more preferably 1000 rpm or more, and most preferably 1500 rpm or more.
The processing time is preferably 1 to 30 minutes, more preferably 5 to 20 minutes and most preferably 10 to 15 minutes.
If the distance between the grindstones, diameter, rotational speed and processing time exceed the above-described upper limit, crystallinity of the cellulose may be impaired and thus elastic modulus may be impaired.
Fiberization temperature at the space between the grindstones is preferably 30 to 90 °C, more preferably 40 to 80 °C and most preferably 50 to 70 °C. If the fiberization temperature is higher than 90 °C, fiberization efficiency may be impaired or the crystallinity of the cellulose may be impaired. If the fiberization temperature is lower than 30 °C, the fiberization effect may be insufficient.

After the mechanical fiberization process is completed, the obtained aqueous cellulose nanofiber is subjected to paper-making and the moisture therein is removed. As a result, non-woven fabric of the cellulose nanofiber can be obtained.

The process of moisture removal is not particularly limited, but may include removing a certain amount of moisture by leaving the aqueous bacterial cellulose or by cold pressing, and then completely removing the moisture by continuously leaving or hot pressing, or removing the moisture of a cold pressed aqueous bacterial cellulose by heat drying or air drying.

Leaving the aqueous bacterial cellulose to remove a certain amount of the moisture means gradually vaporizing the moisture over a long time.

The cold pressing is a process to remove moisture by applying pressure to squeeze a certain amount of moisture without heat. The pressure in the cold pressing is preferably 0.01 to 10 MPa and more preferably 0.1 to 3 MPa. If the pressure is smaller than 0.01 MPa, there is a likelihood that the amount of residual moisture becomes large and if the pressure is larger than 10 MPa, there is a possibility that the obtained bacterial cellulose may be destroyed. The temperature is not particularly limited, but may preferably be the normal temperature from the viewpoint of operability.

Leaving the aqueous bacterial cellulose to completely remove the residual moisture means drying the bacterial cellulose over a long period of time.

The hot pressing is a process to remove moisture by applying heat and pressure to the bacterial cellulose. The residual moisture can be completely removed in this process. The pressure in the hot pressing is preferably 0.01 to 10 MPa and more preferably 0.2 to 3 MPa. If the pressure is smaller than 0.01 MPa, there is a possibility that the moisture is not removed, and if the pressure is larger than 10 MPa, there is a possibility that the bacterial cellulose may be destroyed. The temperature in the hot pressing is preferably 100 to 300 °C and more preferably 110 to 200 °C. If the temperature is lower than 100 °C, removal of moisture will take a longer period of time and if the temperature is higher than 300 °C, there is a possibility that the bacterial cellulose may be decomposed.

The drying temperature in heat drying is preferably 100 to 300 °C and more preferably 110 to 200 °C. If the drying temperature is lower than 100 °C, there is a possibility that the moisture is not removed and if the drying temperature is higher than 300 °C, there is a possibility that the cellulose fiber may be decomposed.
The hot pressing is preferred in order to reduce a coefficient of thermal expansion of the composite material sheet. This is because the hydrogen bond of the fiber entangling part can be further reinforced.

Alternative to the mechanical fiberization process, other processes may be employed to obtain the cellulose fiber from the wood powder. Examples thereof include a high-temperature high-pressure water steaming process in which the hemicellulose-removed sample is exposed to high-temperature and high-pressure steam, and a process in which a phosphate is used.
In the phosphate process, the hemicellulose-removed sample is phosphorylated to reduce the bonding strength between the cellulose fibers and then refined to detangle the fibers. As a result, the cellulose fibers are obtained. For example, the hemicellulose-removed sample is immersed in a solution containing 50 mass% of urea and 32 mass% of phosphoric acid. The cellulose fibers are completely immersed in the solution at 60 °C. The sample is then heated at 180 °C to facilitate phosphorylation. The sample is washed and is subjected to hydrolysis treatment in a 3 mass% of hydrochloric acid aqueous solution at 60 °C for two hours, and then washed again. The phosphorylation is completed after the sample is processed for about 20 minutes at room temperature in a 3 mass% of sodium carbonate solution. The processed sample is then fiberized in the refiner to obtain the cellulose fiber.

### Chemical/Physical Modification

The cellulose fiber formed by the thus-obtained bacterial cellulose and the wood powder-based cellulose may be chemically and/or physically modified to gain improved functionality. Examples of the chemical modification process include addition of a functional group by an acylation process, such as acetylation, allylation, cyanoethylation, acetalization, etherification and isocyanation, and making complex or covered inorganic materials, such as silicate and titanate by chemical reaction or a sol gel process.
The chemical modification process may include immersing a BC sheet or a plant-based cellulose sheet in acetic anhydride and then heating.
An acetylated cellulose fiber may have decreased water absorbability and improved heat-resistance without impairing light transmittance.
The physical modification process may include surface coating of a metal or a ceramic material by a physical vapor deposition (PVD) process, such as vacuum deposition, ion plating and sputtering, a chemical vapor deposition (CVD) process, and plating process such as electroless plating and electrolytic plating.

### [Amorphous Synthetic Resin]

Examples of the amorphous synthetic resin include a thermoplastic or ultraviolet-curable acrylic-based resin, an epoxy-based resin, a polycarbonate-based resin, a polyethersulfone-based resin and a cyclic polyolefin-based resin. The amorphous synthetic resin may used alone or in combination thereof.
Among these amorphous synthetic resins, a low-elasticity epoxy resin having a Young's modulus of 0.1 GPa or less and a low-elasticity epoxy resin having a Young's modulus of 0.1 GPa or less are preferred. These resins may provide the substrate with further increased flexibility.
Young's modulus herein is in accordance with JIS K 7161 and is obtained from the stress with respect to a distortion amount at or below the limit of proportionality in a tensile test on a test piece having a width of 5 mm, a length of 50 mm and a thickness of 50 µm at a deformation velocity of 1 mm per minute.

Preferably, the low-elasticity epoxy resin and the low-elasticity acrylic resin are obtained by ultraviolet curing an uncured material. The resins are obtained by ultraviolet curing which requires no solvent when forming the amorphous synthetic resin and almost 100% of the material can be substantially cured. Thus, an amount of volatile part in the amorphous synthetic resin can be reduced. Accordingly, a vacuum process can be easily employed to form wiring on the flexible substrate.

Examples of the low-elasticity epoxy resin that can be obtained by ultraviolet curing and has a Young's modulus of 0.1 GPa or less include epoxy-based ultraviolet curing resin, such as aliphatic cyclic epoxy resin, bisphenol-type epoxy resin and bromized epoxy resin.
Examples of the material (i.e., the uncured material) of the aliphatic cyclic epoxy resin include 3,4-epoxycyclohexylmethyl-3,4-epoxy cyclohexane carboxylate, 3,4-epoxycyclohexylethyl-3,4-epoxycyclohexane carboxylate, vinylcyclohexene dioxide, allylcyclohexene dioxide, 3,4-epoxy-4-methylcyclohexyl-2-propylene oxide, 2-(3,4-epoxycyclohexyl-5,5-spiro-3,4-epoxy) cyclohexane-m-dioxane, bis(3,4-epoxycyclohexyl)adipate, bis(3, 4-epoxycyclohexylmethyl)adipate, bis(3,4-epoxycyclohexyl)ether, bis(3,4-epoxycyclohexylmethyl)ether and bis(3,4-epoxycyclohexyl)diethyl siloxane.

Examples of the material (i.e., the uncured material) of the bisphenol-type epoxy resin include bisphenol A diglycidyl ether, bisphenol A D diglycidyl ether, bisphenol S diglycidyl ether, hydrogenated bisphenol A diglycidyl ether, bisphenol F diglycidyl ether, bisphenol G diglycidyl ether, tetramethyl bisphenol A diglycidyl ether, bisphenol hexafluoroacetone diglycidyl ether and bisphenol C diglycidyl ether.

Examples of the material (i.e., the uncured material) of the bromized epoxy resin include dibromomethylphenyl glycidyl ether, dibromophenyl glycidyl ether, bromomethylphenyl glycidyl ether, bromophenyl glycidyl ether, dibromomethacrecidyl glycidyl ether, dibromoneopentylglycol diglycidyl ether and brominated phenol novolak-type epoxy resin.

Other epoxy resins may also be included as accessory components in addition to the above-described aliphatic cyclic epoxy resin, bisphenol-type epoxy resin and bromized epoxy resin. Examples of other epoxy resins include epoxy compounds such as polybutadiene diglycidyl ether, poly-1,4-(2,3-epoxy butane)-co-1,2-(3,4-epoxy)-co-1,4-butadienediol, neopentyl glycol diglycidyl ether, 1, 6-hexanediol diglycidyl ether, polyethylene glycol diglycidyl ether, polypropylene glycol diglycidyl ether, phthalic acid diglycidyl ester, trimethylolpropane polyglycidyl ether, diglycerol polyglycidyl ether, polyglycerol polyglycidyl ether, sorbitol polyglycidyl ether, allyl glycidyl ether, 2-ethylhexyl glycidyl ether, phenyl glycidyl ether, phenol penta (oxyethylene) glycidyl ether, p-tert-buthylphenyl glycidyl ether, lauryl alcohol pentadeca (oxyethylene) glycidyl ether, sorbitan polyglycidyl ether, pentaerythritol polyglycidyl ether, triglycidyl tris(2-hydroxyethyl) isocyanurate, resorcine diglycidyl ether, polytetramethylene glycol diglycidyl ether, adipic acid diglycidyl ester, hydroquinone diglycidyl ether, terephthalic acid diglycidyl ester, glycidyl phthalimide, cetyl glycidyl ether, stearyl glycidyl ether, p-octyl phenyl glycidyl ether, p-phenyl phenyl glycidyl ether, glycidyl benzoate, glycidyl acetate, glycidyl butyrate, spiroglycol diglycidyl ether, 1,3-bis-[1-(2,3-epoxy propoxy)-1-trifluoro methyl-2, 2, 2-trifluoroethyl]benzene, 1,4-bis[1-(2,3-epoxy propoxy)-1-trifluoro methyl-2, 2, 2-trifluoroethyl]benzene, 4,4'-bis(2,3-epoxy propoxy)octafluoro biphenyl, tetraglycidyl-m-xylylene diamine, tetraglycidyl diaminodiphenylmethane, triglycidyl-para-aminophenol, triglycidyl-meta-aminophenol, diglycidyl aniline, diglycidyl tribromoaniline, tetraglycidyl bis aminomethyl cyclohexane, tetrafluoropropyl glycidyl ether, octafluoropentyl glycidyl ether, dodecafluorooctyl diglycidyl ether, styrene oxide, limonene diepoxide, limonene monoxide, alpha-pinene epoxide and beta-pinene epoxide.

The low-elasticity epoxy resin can be obtained by ultraviolet curing the materials which can form the epoxy resin. The photopolymerization initiator used in the ultraviolet curing is not particularly limited so long as it reacts with epoxy groups when exposed to ultraviolet rays. Examples of the photopolymerization initiator include an aromatic diazonium salt such as p-methoxybenzenediazonium hexafluorophosphate, an aromatic sulfonium salt such as triphenylsulfonium hexafluorophosphate, an aromatic iodonium salt such as diphenyliodonium hexafluorophosphate, an aromatic iodosyl salt, an aromatic sulfoxonium salt and a metallocene compound.

The amorphous synthetic resin may include a silane coupling agent in order to increase adhesiveness with respect to the thin glass sheet 10.
Examples of the silane coupling agent include gamma-aminopropyl triethoxysilane, N-beta-(aminoethyl)-gamma-aminopropyl trimethoxysilane, N-beta-(aminoethyl)-gamma-aminopropyl triethoxysilane, N-bis[beta-(aminoethyl)]-gamma-aminopropyl methyl dimethoxysilane, gamma-mercapto propyltrimethoxysilane, gamma-mercapto propyltriethoxysilane, gamma-methacryloxypropyltrimethoxysilane, gamma-glycidoxypropyltrimetoxysilane, N-beta-(N-vinylbenzyl aminoethyl)-gamma-aminopropyl trimethoxysilane hydrochloride, methyltrimetoxysilane, methyltriethoxysilane, vinyltriacetoxysilane, gamma-chloropropyltrimetoxysilane, hexamethyldisilazane, gamma-anilino propyltrimethoxysilane, vinyltrimetoxysilane, octadecyl dimethyl[3-(trimethoxysilyl) propyl]ammonium chloride, gamma-chloropropyl methyl dimethoxysilane, gamma-mercaptopropylmethyl dimethoxysilane, methyltrichlorosilane, dimethyldichlorosilane, trimethylchlorosilane, vinyltriethoxysilane, benzyltrimethylsilane, vinyl tris(2-methoxyethoxy)silane, gamma-methacryloxypropyl tris(2-methoxyethoxy)silane, beta-(3, 4-epoxycyclohexyl) ethyltrimethoxysilane, gamma-ureidopropyltriethoxysilane, gamma-isocyanuric propyltriethoxysilane and n-octyltriethoxysilan.

In addition, cyclohexyl fluorinated epoxy resin represented by the following chemical formula (1) and tetrafluoropropyl glycidyl ether represented by the following chemical formula (2) may also be included.

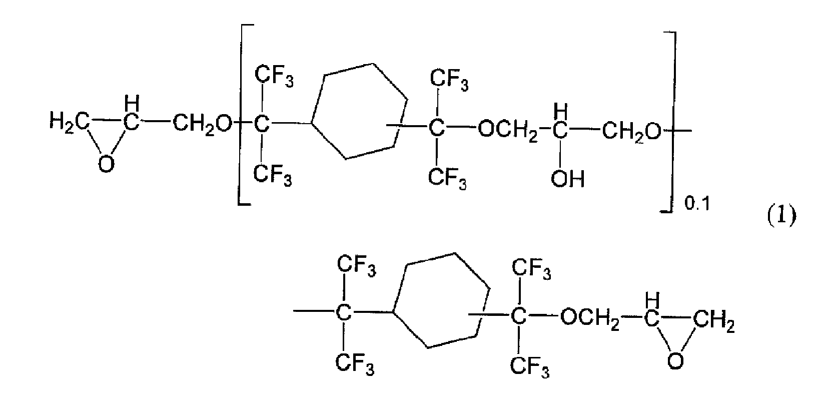

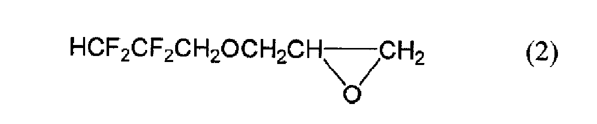

Examples of the low-elasticity acrylic resin having a Young's modulus of 0.1 GPa or less obtained by ultraviolet curing include acrylic ultraviolet curing resin such as aliphatic linear diacrylic resin and aliphatic linear dimethacrylic resin.
Examples of the materials (i.e., monomer) of the aliphatic linear diacrylic resin and aliphatic linear dimethacrylic resin include diacrylates of polypropylene glycol and/or of polyethylene glycol, and polypropylene glycol and/or dimethacrylate, represented by the following chemical formula (3). In chemical formula (3), R represents a hydrogen atom or a methyl group.

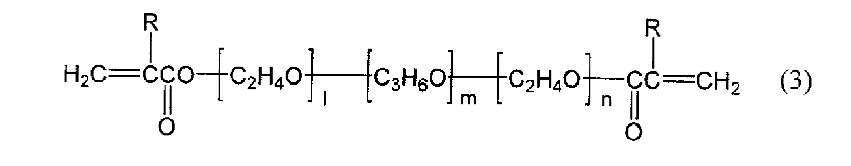

Examples of the compound represented by chemical formula (3) include a compound of which a number of units of an ethylene glycol portion represented by (1+n) is 6 and the number of units of a propylene glycol portion represented by m is 12.
Physical properties, such as elastic modulus, of the compound represented by chemical formula (3), can be suitably controlled by the number of units of the propylene glycol portion, the number of units of the ethylene glycol portion and the ratio of the units of the propylene glycol and the units of the ethylene glycol.

The low-elasticity acrylic resin can be obtained by ultraviolet curing the materials which can form the acrylic resin. Examples of the radical polymerization initiator used in the ultraviolet curing include organic peroxides such as benzoyl peroxide (BPO) and azo compounds such as azobisisobutyronitrile (AIBN). These radical polymerization initiators decompose when irradiated with light and generate two radicals, which may be used to proceed chain-reaction of the radical polymerization of the materials. The radical polymerization initiator is suitably selected in consideration of the wavelength of the ultraviolet rays to be irradiated and compatibility with the monomer to react with.

The refractive index of the low-elasticity epoxy resin and the low-elasticity acrylic resin described above can be controlled to be from 1.40 to 1.62, especially about 1.55. The refractive index can be adjusted to the refractive index of the cellulose nanofiber. In this manner, the transparency of the composite material sheet 20 can be further improved.
In order to control the refractive index of the acrylic-based resin, an aromatic compound may be introduced into a constitutional unit, or a bromine or sulfur substitution to the acrylic resin may be partially performed. In order to increase the refractive index by adding an aromatic compound as a constitutional unit, a skeleton of bisphenol A can be introduced.

The glass transition temperature (Tg) of the amorphous synthetic resin is preferably 120 °C or higher, more preferably 150 °C or higher, and most preferably 170 °C or higher. If the glass transition temperature (Tg) of the amorphous synthetic resin is less than 120 °C, the heat resistance of the obtained composite material sheet 20 becomes insufficient.
The upper limit of the glass transition temperature (Tg) of the amorphous synthetic resin is particularly defined, but usually 230 °C or less.
The glass transition temperature (Tg) of the amorphous synthetic resin herein is measured by the DSC method.

### [Physical Properties of Composite Material Sheet]

The composite material sheet 20 preferably has the following physical properties:
a Young's modulus of preferably 10 GPa or less, more preferably 3 GPa or less and most preferably 0.1 GPa or less;
a coefficient of linear thermal expansion of preferably 15 ppm/K or less, more preferably 1 to 10 ppm/K and most preferably 1 to 5 ppm/K;
breaking strain of preferably 20 to 60%; and
parallel rays transmittance of preferably 70% or more, and more preferably 80% or more at a thickness of 50 µm
If the composite material sheet 20 has such physical properties, the flexible substrate 1 of desired physical properties can be obtained easily.

The content of the cellulose nanofiber in the composite material sheet is preferably 1 mass% or more. The composite material sheet having the content of the cellulose nanofiber 1 mass% or more may further improve the bending strength.

The thickness of the composite material sheet 20 is 100 µm or less and preferably 50 µm or less. If the thickness of the composite material sheet 20 is greater than 100 µm, flexibility becomes poor and it becomes difficult to provide a lightweight sheet.
The thickness of the composite material sheet 20 is preferably 20 µm or more, and more preferably 30 µm or more. The composite material sheet 20 having a thickness of not less than 20 µm can easily be produced.

### [Fabrication method of Flexible Substrate]

In an exemplary method of fabricating the flexible substrate 1, an aggregation of cellulose nanofiber is impregnated with a liquid material for impregnation which can form an amorphous synthetic resin. The impregnated aggregation of cellulose nanofiber is then affixed to the thin glass sheet 10. The liquid material for impregnation is subsequently cured. In another method of fabricating the flexible substrate 1, an aggregation of cellulose nanofiber is impregnated with a liquid material for impregnation. The liquid material for impregnation is cured to form a composite material sheet which is then affixed to a thin glass sheet.

Examples of the liquid material for impregnation include a fluidized amorphous synthetic resin, a material of the fluidized amorphous synthetic resin, a fluidized material of an amorphous synthetic resin, a fluidized material of a material of the amorphous synthetic resin, a solution containing an amorphous synthetic resin, and a solution containing a material of the amorphous synthetic resin.

Examples of the fluidized amorphous synthetic resin include an amorphous synthetic resin having fluidity.
Examples of the material of the fluidized amorphous synthetic resin include a polymerization intermediate, such as a prepolymer and an oligomer, which can form the amorphous synthetic resin.
Examples of the fluidized material of an amorphous synthetic resin include a hot melt of thermoplastic amorphous synthetic resin.
Examples of the fluidized material of a material of the amorphous synthetic resin include a hot melt of solid polymerization intermediate such as a prepolymer and an oligomer.

The solution containing an amorphous synthetic resin and examples of the solution containing a material of the amorphous synthetic resin means a solution or slurry in which an amorphous synthetic resin or a material thereof is dissolved or dispersed in solvent and the like. The solvent is suitably selected in accordance with the amorphous synthetic resin or the material thereof. If the solvent is to be vaporized to be removed in a subsequent process, the solvent preferably have a boiling point at or below a temperature at which no decomposition of the amorphous synthetic resin or the material thereof is caused. Examples of the solvent include alcohols such as ethanol, methanol and isopropyl alcohol, ketones such as acetone, ethers such as tetrahydrofuran, mixtures thereof, mixtures thereof with water, or acrylic monomers which themselves have polymerizability and cross-linking ability.

The aggregation of cellulose nanofiber impregnated with the liquid material for impregnation may be a single layer product of cellulose nanofiber or a laminated product having a plurality of cellulose nanofiber sheets are laminated together.
Part or all of the impregnation process is preferably performed under varying pressure by increasing or reducing the pressure. By the reduction or the increase in pressure, air existing between the cellulose nanofiber can be substituted by the liquid material for impregnation, thereby easily removing residual air bubbles.

A preferred depressurization condition is from 0.133 kPa (1 mmHg) to 93.3 kPa (700 mmHg). If the depressurization condition is greater than 93.3 kPa (700 mmHg), air is not completely removed and residual air bubbles may remain between the cellulose nanofiber. Although the depressurization condition may be lower than 0.133 kPa (1 mmHg), there is a likelihood that depressurization equipment becomes large scale.
The processing temperature of the impregnation process under the depressurization condition is preferably 0 °C or higher, and more preferably 10 °C or higher. If the temperature is lower than 0 °C, removal of air may be insufficient and air bubbles may remain between the cellulose nanofiber. If a solvent is used as the liquid material for impregnation, for example, the upper limit of the temperature is preferably the boiling point (i.e., the boiling point under the depressurization condition) of the solvent. If the temperature becomes higher than the boiling point, the solvent may vaporize rapidly, resulting in air bubbles that are likely to remain.

The preferred pressurization condition is 1.1 to 10 MPa. If the pressurization condition is lower than 1.1 MPa, removal of air may be insufficient and air bubbles may remain between the cellulose nanofiber. Although the pressurization condition may be higher than 10 MPa, there is a likelihood that pressurization equipment becomes large scale.
The processing temperature in the impregnation process under the pressurization condition is preferably 0 to 300 °C, more preferably 10 to 200 °C and most preferably 30 to 100 °C. If the temperature is lower than 0 °C, removal of air may be insufficient and air bubbles may remain between the cellulose nanofiber. On the other hand, if the temperature is higher than 300 °C, there is a possibility that the amorphous synthetic resin may deform or discolor.

In order to cure the liquid material for impregnation that the cellulose nanofiber is impregnated with, the method of curing the liquid material for impregnation can be employed. For example, in order to cure the liquid material for impregnation which is a material of the fluidized amorphous synthetic resin, a polymerization reaction, a crosslinking reaction and a chain elongation reaction can be employed.
In order to cure the liquid material for impregnation which is a fluidized material of the amorphous synthetic resin fluidized by a graft reaction, solidification by cooling can be employed.
In order to cure the liquid material for impregnation which is a fluidized material of the material of the amorphous synthetic resin, a combination of cooling and a polymerization reaction, a crosslinking reaction or a chain elongation reaction can be employed.
In order to cure the liquid material for impregnation which is a solution of the amorphous synthetic resin, the solvent in the solution can be removed by evaporating or air-drying.
In order to cure the liquid material for impregnation which is a solution of the material of the amorphous synthetic resin, a combination of removal of the solvent in the solution and a polymerization reaction, a crosslinking reaction or a chain elongation reaction can be employed.
The evaporative removal may include evaporative removal under depressurization as well as evaporative removal under normal pressure.

The composite material sheet can be affixed to the thin glass sheet by using an adhesive such as an epoxy resin adhesive.
The composite material sheet may be obtained by, for example, a fabricated cellulose nanofiber sheet being impregnated with the liquid material for impregnation and being cured.
The composite material sheet may also be obtained without making the cellulose nanofiber into a sheet-shape. The fabricating method of the composite material without having a sheet-shaping process will be described in the following manner.

In a first process, after a replacement process in which the moisture included in a fiber aggregation of aqueous cellulose (hereinafter, referred to as "aqueous fiber aggregation") is replaced by a liquid having compatibility with at least one of water and the liquid material for impregnation (hereinafter, referred to as "medium solution"), a precursor for producing the fiber reinforced composite material in which a fiber aggregation is impregnated with the medium solution having compatibility with at least the liquid material for impregnation. In a second process, the medium solution included in the precursor for producing the fiber reinforced composite material obtained in the first process is replaced by the liquid material for impregnation. In a third process, the liquid material for impregnation is cured.

### First Process

Moisture included in the aqueous fiber aggregation is replaced by a medium solution which has compatibility with at least one of water and the liquid material for impregnation to obtain a precursor for producing the fiber reinforced composite material.

"Compatibility" used herein means not to cause separation when two different liquids are mixed at a certain ratio and left.

The medium solution preferably has compatibility with water and with the liquid material for impregnation in order to smoothly replace water contained in the aqueous fiber aggregation with the medium solution in the first process and to smoothly replace the medium solution contained in the fiber aggregation with the liquid material for impregnation in the second process, which will be described later. The medium solution preferably has a boiling point lower than that of the water or the liquid material for impregnation. Preferred examples thereof include water-soluble organic solvents such as alcohols such as methanol, ethanol, propanol and isopropanol; ketones such as acetone; ethers such as tetrahydrofurans and 1,4-dioxane; amides such as N,N-dimethylacetamide and N,N-dimethylformamide; carboxylic acids such as acetic acid; and nitrils such as acetonitrile; and aromatic heterocyclic compounds such as pyridine. Among these, ethanol and acetone are especially preferred from the viewpoints of availability and handling ability. These water-soluble organic solvents can be used alone or in combination thereof.

The medium solution is selected to have compatibility with one or both of water and the liquid material for impregnation. If the medium solution has compatibility in with the liquid material for impregnation, the medium solution is selected in accordance with the types of the liquid material for impregnation. In some cases, the medium solution may be water, a mixture of water and the water-soluble solvent, or an aqueous solution in which an inorganic compound is dissolved.

The method of replacing water in the aqueous fiber aggregation by the medium solution is not particularly limited. Examples thereof may include a method of immersing the aqueous fiber aggregation in the medium solution and leaving for a predetermined time so that water in the aqueous fiber aggregation leaches out to the medium solution, then exchanging the medium solution which contains the leached water. The replacement by immersion is performed at a temperature of about 0 to 60 °C and normally at room temperature in order to prevent vaporization of the medium solution.

The replacement ratio of the water by the medium solution is most preferably 100%. However, it is preferred to replace at least 10% of the water in the aqueous fiber aggregation by the medium solution.

It is preferred to remove a part of the moisture included in the fiber aggregation by cold pressing the aqueous fiber aggregation before the water in the aqueous fiber aggregation is replaced by the medium solution in order to efficiently replace water by the medium solution.

The degree of cold pressing is suitably determined so that the fiber reinforced composite material having a desired fiber content can be obtained by a combination of the cold pressing and pressing before the replacement of the medium solution by the liquid material for impregnation in the precursor for producing the fiber reinforced composite material which will be described later. In general, the degree of cold pressing is preferably about 1/2 to 1/20 in the thickness of the aqueous fiber aggregation before being pressed. The pressure of the cold pressing is determined within a range of 0.01 to 100 MPa in accordance with the degree of pressing (if the cold pressing is performed at the pressure of 10 MPa or more, the press speed may be reduced to prevent destroy of the fiber aggregation). The duration of the cold pressing is determined within a range of 0.1 to 30 minutes in accordance with the degree of pressing. The press temperature is in the range of about 0 to 60 °C from the same reason as that of the temperature condition for the replacement of the above-described water and the medium solution and usually is room temperature. The thickness of the aqueous fiber aggregation reduced by the pressing is substantially kept even after the replacement of water with the medium solution. However, the pressing is not always necessary and the aqueous fiber aggregation obtained in the first process may be directly immersed in a medium solution to replace the water by the medium solution.

In this manner, a precursor for producing the fiber reinforced composite material in which fiber aggregation is impregnated with the medium solution is obtained by replacing water in the aqueous fiber aggregation with the medium solution. The fiber content of the precursor for producing the fiber reinforced composite material varies depending on the degree of pressing before the replacement of water by the medium solution, but is 0.1 mass% or more, preferably 10 to 70 mass% and more preferably about 20 to 70 mass%.

In the first process, the replacement of water in the aqueous fiber aggregation with the medium solution may be performed in two or more steps. That is, first and second medium solutions having compatibility with both water and the liquid material for impregnation are prepared: the first medium solution, which may be ethanol, has greater compatibility with water than that of the second medium solution; and the second medium solution, which may be acetone, has greater compatibility with the liquid material for impregnation than that of the first medium solution. First, water in the aqueous fiber aggregation is replaced by the first medium solution so that a fiber aggregation impregnated with the first medium solution is obtained. Subsequently, the first medium solution in the fiber aggregation impregnated with the first medium solution is replaced by the second medium solution so that a fiber aggregation impregnated with the second medium solution can be obtained as a precursor for producing the fiber reinforced composite material. Alternatively, three or more different medium solutions may be used for replacement in three or more steps.

### Second Process

The medium solution in the precursor for producing the fiber reinforced composite material is replaced by the liquid material for impregnation. The medium solution with which the precursor for producing the fiber reinforced composite material is impregnated here has compatibility at least with the liquid material for impregnation.
In the replacement, the precursor for producing the fiber reinforced composite material may be cold pressed to remove a part of the medium solution in the precursor for producing the fiber reinforced composite material.

The degree of cold pressing is suitably determined in accordance with the desired fiber content of the fiber reinforced composite material. In general, the degree of cold pressing is preferably about 1/2 to 1/20 the thickness of the precursor for producing the fiber reinforced composite material before being pressed. The pressure of the cold pressing is determined within a range of 0.01 to 100 MPa in accordance with the degree of pressing (if the cold pressing is performed at the pressure of 10 MPa or more, the press speed may be reduced to prevent destroy of the fiber aggregation). The duration of the cold pressing is determined within a range of 0.1 to 30 minutes in accordance with the degree of pressing. The press temperature is in the range of about 0 to 60 °C and preferably is room temperature in usual. The pressing is performed to control the fiber content of the finally obtained fiber reinforced composite material. Accordingly, the pressing is not necessarily performed if the fiber content is fully controlled by the pressing in the first process. In this case, the precursor for producing the fiber reinforced composite material obtained in the first process may be directly used for replacement of the medium solution with the liquid material for impregnation.

The method of replacing the medium solution in the precursor for producing the fiber reinforced composite material by the liquid material for impregnation is not particularly limited, but it is preferred to immerse the precursor for producing the fiber reinforced composite material in the liquid material for impregnation and keep the precursor under a depressurization condition. In this manner, the medium solution in precursor for producing the fiber reinforced composite material vaporizes and the liquid material for impregnation enters the fiber aggregation instead so that the medium solution in the precursor for producing the fiber reinforced composite material is replaced by the liquid material for impregnation.

The depressurization condition is not particularly limited, but 0.133 kPa (1 mmHg) to 93.3 kPa (700 mmHg) is preferred. If the depressurization condition is greater than 93.3 kPa (700 mmHg), removal of the medium solution may be insufficient and there is a possibility that the medium solution remains between the fibers of the fiber aggregation. Although the depressurization condition may be lower than 0.133 kPa (1 mmHg), there is a likelihood that depressurization equipment becomes large scale.

The processing temperature of the replacing process under the depressurization condition is preferably 0 °C or higher, and more preferably 10 °C or higher. If the processing temperature is lower than 0 °C, removal of the medium solution may be insufficient and there is a likelihood that the medium solution remains between the fibers. If a solvent is used as the liquid material for impregnation, for example, the upper limit of the temperature is preferably the boiling point (i.e., the boiling point under the depressurization condition) of the solvent. If the temperature becomes higher than the boiling point, the solvent may vaporize rapidly, resulting in the air bubbles that are likely to remain.

The medium solution in the precursor for producing the fiber reinforced composite material can be smoothly replaced by the liquid material for impregnation also by repeating depressurization and pressurization alternately in a state in which the precursor for producing the fiber reinforced composite material is immersed in the liquid material for impregnation.

The depressurization condition in this case is the same as that of the above-described condition. The pressurization condition is preferably 1.1 to 10 MPa. If the pressurization condition is lower than 1.1 MPa, removal of the medium solution may be insufficient and the medium solution may remain between the fibers. Although the pressurization condition may be higher than 10 MPa, there is a likelihood that pressurization equipment becomes large scale.

The processing temperature of the impregnation process under pressurization condition is preferably 0 to 300 °C and more preferably 10 to 100 °C. If the temperature is lower than 0 °C, removal of the medium solution may become insufficient and, in some cases, the medium solution remains between fibers. On the other hand, if the processing temperature is higher than 300 °C, there is a possibility that the amorphous synthetic resin may become deformed.

Upon replacement of the medium solution by the liquid material for impregnation, a plurality of layers of the precursor for producing the fiber reinforced composite material can be laminated and immersed in the liquid material for impregnation. Alternatively, the precursor for producing the fiber reinforced composite material after the medium solution is replaced by the liquid material for impregnation may be laminated and subjected to a subsequent curing process.

The replacement ratio of the medium solution in the precursor for producing the fiber reinforced composite material by the liquid material for impregnation is the most preferably 100%. However, it is preferred to replace at least 0.2% of the medium solutions in the precursor for producing the fiber reinforced composite material by the liquid material for impregnation.

### Third Process

In order to cure the liquid material for impregnation that the fiber aggregation is impregnated with, the method of curing the liquid material for impregnation can be employed. For example, in order to cure the liquid material for impregnation which is a fluidized amorphous synthetic resin, a crosslinking reaction and a chain elongation reaction can be employed. In order to cure the liquid material for impregnation which is a material of the fluidized amorphous synthetic resin, a polymerization reaction, a crosslinking reaction and a chain elongation reaction can be employed.

In order to cure the liquid material for impregnation which is a fluidized material of the amorphous synthetic resin, cooling can be employed. In order to cure the liquid material for impregnation which is a fluidized material of the material of the amorphous synthetic resin, a combination of cooling and a polymerization reaction, a crosslinking reaction or a chain elongation reaction can be employed.

In order to cure the liquid material for impregnation which is a solution of the amorphous synthetic resin, the solvent in the solution can be removed by evaporating or air-drying. In order to cure the liquid material for impregnation which is a solution of a material of the amorphous synthetic resin, a combination of removal of the solvent in the solution and a polymerization reaction, a crosslinking reaction or a chain elongation reaction can be employed. The evaporative removal may include evaporative removal under depressurization as well as evaporative removal under normal pressure.

In the fabricating method of a composite material sheet without having a sheet-shaping process as described above, a composite material sheet having a low fiber content (i.e., a composite material sheet having fiber content of about 1 to 50 mass%) can be obtained easily.

### [Operation Effect of Flexible Substrate]

The flexible substrate 1 according to the present invention has an excellent gas barrier property and surface smoothness because it comprises the thin glass sheet 10. Although the thin glass sheet 10 alone has low bending strength, the flexible substrate 1 according to the present invention has the composite material sheet 20, laminated on the thin glass sheet 10 to operate as a reinforcement material. Thus, the flexible substrate 1 has breaking strain that is twice or more greater than that of the thin glass sheet 10, which provides sufficient bending strength. Since the composite material sheet 20 formed by resin and fiber is lightweight, the flexible substrate 1 incorporating the same is also lightweight.

Generally, a sheet in which layers of different materials are laminated together may easily separate or warp when heated due to different coefficients of thermal expansion. In flexible substrate 1 according to the present invention, however, separation or warping when heated is prevented in spite of its laminated structure of the thin glass sheet 10 and the composite material sheet 20. This is considered because the thermal expansion toward the surface direction is controlled in the composite material sheet 20. The substrate in which separation or warping is prevented can be suitably used as a wiring board or a substrate for an organic device.
The composite material sheet 20 in the flexible substrate 1 according to the present invention is easy to increase transparency since the refractive index of the aggregation of cellulose nanofiber can be easily adjusted to that of the amorphous synthetic resin.

### EXAMPLES

### Example 1

A cultivation liquid was added to strains of freeze-dried acetic acid bacteria and the obtained liquid was left for static cultivation for a week (at 25 to 30 °C). A bacterial cellulose was produced on a cultivation liquid surface. A small amount of cultivation liquid was taken from the strains at thickened areas of the produced bacterial cellulose, and was added to a new cultivation liquid. The cultivation liquid was placed into a large incubator and then subjected to static cultivation for 7 to 30 days at 25 to 30 °C. A solution (i.e., a Schramm-Hestrin cultivation liquid) containing 2 mass% of glucose, 0.5 mass% of Bacto yeast extract, 0.5 mass% of bacto peptone, 0.27 mass% of disodium hydrogenphosphate, 0.115 mass% of citrate and 0.1 mass% of magnesium sulfate heptahydrate, with the pH adjusted to 5.0 by hydrochloric acid was used as a cultivation liquid.

The thus-produced bacterial cellulose was taken out of the cultivation liquid, boiled in a 2 mass% of alkaline aqueous solution for 2 hours. Then, bacterial cellulose was taken out of the alkali treatment solution and sufficiently washed with water. The alkali treatment solution was removed and the bacteria in the bacterial cellulose was dissolved and removed. Subsequently, the obtained aqueous bacterial cellulose (bacterial cellulose having 95 to 99 mass% of moisture content) was hot pressed under 2 MPa for three minutes at 120 °C, and a BC sheet (0 mass% of moisture content) having a thickness of about 50 µm was obtained. The physical properties of the obtained BC sheet were as follows.

Coefficient of linear thermal expansion: 2 to 3 ppm/K
Young's modulus: 12.1 GPa
Breaking strain: 4%
Percentage of void: 60%
Crystalline cellulose content: 60%
Parallel rays transmittance: 45% when the thickness is 50 µm

The obtained BC sheet was immersed in uncured ultraviolet-curable epoxy-based resin (having a Young's modulus of 0.01 GPa after curing) under the commercial name of E3410 (hereinafter, referred to as a "uncured epoxy resin A") available from NTT Advanced Technology Corporation for 12 hours. The composite material sheet to be obtained had a thickness of 60 µm and included 56 mass% of the BC sheet.
Subsequently, the obtained composited material sheet was adhered to a thin glass sheet having a thickness of 30 µm, and then it was irradiated with ultraviolet rays (total irradiation energy amount; 11 J/cm²) to cure the resin. The sheet was then annealed at 60 °C for 30 minutes under the atmospheric pressure and the air atmosphere. In this manner, a flexible substrate which has the thin glass sheet and the composite material sheet was obtained.

### Example 2

A flexible substrate was obtained in the same manner as in Example 1 except that the uncured epoxy resin A was replaced by an uncured ultraviolet-curable acrylic-based resin (having a Young's modulus of 0.02 GPa after curing) under the commercial name of NK1206PE available from Mitsubishi Chemical Corporation and that a total irradiation energy amount of the ultraviolet ray to cure the resin is 22 J/cm².

### Example 3

A flexible substrate was obtained in the same manner as in Example 1 except that the BC sheet was replaced by a wood powder-based cellulose nanofiber nonwoven fabric sheet, that the uncured epoxy resin A was replaced by the NK1206PE available from Mitsubishi Chemical Corporation and that a total irradiation energy amount of the ultraviolet ray to cure the resin was 22 J/cm².
The wood powder-based cellulose nanofiber nonwoven fabric was fabricated in the following manner. First, the wood powder was degreased by an alcohol benzene extraction process, and then subjected to lignin removal process by the Wise method described above. The degreased and lignin-removed wood powder was immersed in a 5 mass% of potassium hydroxide solution for one night to remove hemicellulose. In this manner, a 1 mass% of aqueous suspension was prepared. Subsequently, the aqueous suspension was subjected to a mechanical fiberization process using a grinder ("Serendipiter MKCA6-3" available from Masuko Sangyo Co., Ltd.). In particular, the aqueous suspension was made to pass between discs rotating at 1500 rpm in a substantially contacting state outward from the center to fiberize the suspension one time. In this manner, aqueous cellulose nanofiber was obtained. The obtained aqueous cellulose nanofiber was subjected to papermaking to remove the moisture and was formed as a sheet. The obtained sheet was hot pressed at 120 °C for four minutes under the pressure of 2 MPa to completely remove the moisture. In this manner, a wood powder -based cellulose nanofiber nonwoven fabric having a thickness of 40 µm was obtained.

### Example 4

A flexible substrate was obtained in the same manner as in Example 1 except that the uncured epoxy resin A was replaced by an uncured ultraviolet-curable epoxy-based resin (having a Young's modulus of 0.008 GPa after curing) under the commercial name of E3409 available from NTT Advanced Technology Corporation.

### Example 5

A flexible substrate was obtained in the same manner as in Example 1 except that the uncured epoxy resin A was replaced by an uncured ultraviolet-curable acrylic-based resin (having a Young's modulus of 0.044 GPa after curing) under the commercial name of KYO02 available from Mitsubishi Chemical Corporation and that a total irradiation energy amount of the ultraviolet ray to cure the resin was 22 J/cm².

### Example 6

A flexible substrate was obtained in the same manner as in Example 1 except that the uncured epoxy resin A was replaced by an uncured ultraviolet-curable epoxy-based resin (having a Young's modulus of 2.8 GPa after curing) under the commercial name of E2689 available from NTT Advanced Technology Corporation and that a total irradiation energy amount of the ultraviolet ray to cure the resin is 22 J/cm².

### Example 7

A flexible substrate was obtained in the same manner as in Example 1 except that the uncured epoxy resin A was replaced by tricyclodecane dimethacrylate which is an uncured ultraviolet-curable acrylic-based resin (having a Young's modulus of 2.0 GPa after curing), that a total irradiation energy amount of the ultraviolet ray to cure the resin was 22 J/cm² and that the obtained sheet was annealed at 180 °C for 120 minutes under vacuum atmosphere after curing.

### Example 8

A flexible substrate was obtained in the same manner as in Example 1 except that the thin glass sheet having a thickness of 30 µm was replaced by a thin glass sheet having a thickness of 50 µm

### Example 9

Aqueous bacterial cellulose was boiled for two hours in an aqueous sodium hydroxide solution and then washed with running water. Then, the aqueous bacterial cellulose was compressed under 0.1 MPa for one minute at room temperature. Subsequently, the aqueous bacterial cellulose was immersed in acetone and the moisture in the bacterial cellulose was replaced by acetone. The obtained acetone-substituted bacterial cellulose was immersed in a reaction solution (containing 100 mL of toluene, 100 mL of acetic acid and 10 mL of acetic anhydride) contained in a petri dish and was shaken for an hour at room temperature. Then, 0.2 mL of perchloric acid was added to the reaction solution and the bacterial cellulose was shaken for an hour at room temperature. In this manner, acetylated bacterial cellulose was obtained. Methanol was added to the reaction solution to halt the reaction. The obtained acetylated bacterial cellulose was immersed in ethanol to remove the reaction solution inside. The acetylated bacterial cellulose was squeezed to the thickness of about 60 µm and then immersed in an acrylic-based resin (ABPE10 available from Mitsubishi Chemical Corporation, having Young's modulus of 0.03 GPa) under depressurization (-0.08 MPa) for 12 hours and an impregnated BC sheet was obtained. The obtained impregnated BC sheet was irradiated with ultraviolet ray (22 J/cm²) to cure the acrylic-based resin and a composite material sheet was obtained. The obtained composite material sheet had a thickness of 66 µm and cellulose content of 62 mass%.
The thus-obtained composite material sheet was made to adhere to a thin glass sheet having a thickness of 30 µm using an epoxy adhesive (AT7195 available from NTT Advanced Technology Corporation). The obtained sheet was irradiated with ultraviolet ray (11 J/cm²) and then annealed at 60 °C for 30 minutes under the atmospheric pressure and the air atmosphere. In this manner, a flexible substrate having the thin glass sheet and the composite material sheet was obtained.

### Example 10

The wood powder-based cellulose nanofiber sheet obtained in Example 3 was impregnated with tricyclodecane dimethacrylate which was an uncured ultraviolet-curable acrylic-based resin (having a Young's modulus of 2.0 GPa and a glass transition temperature (Tg) of 180 °C after curing). The sheet was then irradiated with ultraviolet ray and then annealed at 180 °C for 120 minutes under the vacuum atmosphere. In this manner, a composite material sheet was obtained. The thus-obtained composite material sheet was made to adhere to a thin glass sheet as in Example 9 to provide a flexible substrate.

### Comparative Example 1

A flexible substrate was obtained in the same manner as in Example 1 except that the thin glass sheet having a thickness of 30 µm was replaced by a thin glass plate having a thickness of 150 µm

### Comparative Example 2

A flexible substrate was obtained in the same manner as in Example 1 except that the composite material sheet had a thickness of 150 µm

### Comparative Example 3

A composite material sheet was used as a flexible substrate.

The flexible substrates of Example 1 to 10 and Comparative Examples 1 to 3 were evaluated regarding breaking strain, bending strength, parallel rays transmittance and substrate suitability. The result was shown in Tables 1 and 2.

### [Breaking Strain]

In accordance with JIS K 7161, the strain at which a test piece fractures (i.e., broken) was obtained as a proportion (%) with respect to the chuck distance of the original test piece in a tensile test on a test piece having a width of 5 mm, a length of 50 mm and a thickness of 50 µm at a deformation velocity of 1 mm per minute.

### [Bending Strength]

In accordance with JIS K 7203, a bending test was conducted on a test piece having a width of 5 mm, a length of 50 mm and a thickness of 50 µm at a deformation velocity 1 mm per minute and the bending strength and the elastic modulus in bending were obtained.

### [Parallel Rays Transmittance]

### <Measuring Device>

"UV-4100 spectrophotometer" (solid sample measurement system) available from Hitachi High-Technologies Corporation was used.

### <Measuring Conditions>

A 6 x 6 mm-sized light source mask was used. A measuring sample was placed 22 cm away from the open end of the integrating sphere and the light intensity was measured. At this position, diffuse transmission light was removed and only the linear transmitted light reached the light-receiving section inside the integrating sphere.
No reference sample was used. Since there was no reference (i.e., reflection produced due to the refractive index difference between the sample and the air. If Fresnel reflection exists, the parallel rays transmittance of 100% is not practical.), loss of transmittance caused by Fresnel reflection existed.
The scanning speed was 300 nm per minute. The light source was a tungsten lamp or a deuterium lamp. The light source was switched at 340 nm.

### [Suitability as Flexible Substrate]

The obtained flexible substrates are comprehensively evaluated in terms of flexibility, surface smoothness, gas barrier property, an amount of volatile portion and mechanical properties (e.g., breaking strain and bending strength).
O: highly suitable as a flexible substrate and is practical
△: less suitable as a flexible substrate
X: not suitable as a flexible substrate

**Table 1**

| Example No. | 1 | 2 | 3 | 4 | 5 | 6 | 7 | 8 | 9 | 10 |
|---|---|---|---|---|---|---|---|---|---|---|
| Breaking strain (%) | 2.8 | 2.7 | 3.1 | 2.6 | 2.2 | 1.5 | 1.7 | 1.6 | 2.5 | 1.7 |
| Bending strength (GPa) | 320 | 320 | 290 | 320 | 320 | 340 | 340 | 390 | 310 | 330 |
| Parallel rays transmittance (%) | 83 | 75 | 85 | 85 | 80 | 79 | 80 | 83 | 78 | 80 |
| Substrate suitability | ○ | ○ | ○ | ○ | ○ | ○ | ○ | ○ | ○ | ○ |

**Table 2**

| Comparative Example No. | 1 | 2 | 3 |
|---|---|---|---|
| Breaking strain (%) | 0.6 | 1.5 | 5.0< |
| Bending strength (GPa) | 430 | 390 | 260 |
| Parallel rays transmittance (%) | 83 | 80 | 83 |
| Substrate suitability | Δ | Δ | X |

The flexible substrates of Examples 1 to 10 each of which included the thin glass sheet and the composite material sheet laminated together had excellent flexibility, surface smoothness and gas barrier property and sufficient breaking strain and bending strength and were highly transparent.
The substrate of Comparative Example 1 which included the glass sheet having a thickness greater than 50 µm and the composite material sheet laminated together, however, had sufficient bending strength but had poor breaking strain and flexibility, and was thus less suitable as a flexible substrate.
The substrate of Comparative Example 2 which includes the glass sheet and the composite material sheet having a thickness greater than 100 µm laminated together had sufficient bending strength but was poor in flexibility, and was thus less suitable as a flexible substrate.
The substrate of Comparative Example 3 which includes no thin glass sheet had poor surface smoothness and gas barrier property, and was thus not suitable as a flexible substrate.

### INDUSTRIAL APPLICABILITY

The flexible substrate according to the present invention can be applied to a substrate material of a wiring board, a window material for mobile devices, a base sheet for organic devices, especially a sheet for flexible OLEDs and a surface light illuminating sheet. The flexible substrate according to the present invention can also be applied to a flexible optical waveguide substrate and an LCD substrate.
The flexible substrate according to the present invention can be suitably employed in a roll-to-roll process.

## Claims

1. A flexible substrate formed of a thin glass sheet having a thickness of 50 µm or less and a composite material sheet having a thickness of 100 µm or less which are laminated together, the composite material sheet being formed of a composite material of an aggregation of cellulose nanofiber and amorphous synthetic resin.

2. The flexible substrate according to claim 1, wherein the cellulose nanofiber is a plant-based cellulose.

3. The flexible substrate according to claim 1, wherein the cellulose nanofiber is a bacterial cellulose.

4. The flexible substrate according to any one of claims 1 to 3, wherein the amorphous synthetic resin is low-elasticity epoxy resin having a Young's modulus of 0.1 GPa or less.

5. The flexible substrate according to any one of claims 1 to 3, wherein the amorphous synthetic resin is low-elasticity acrylic resin having a Young's modulus of 0.1 GPa or less.

6. The flexible substrate according to any one of claims 1 to 5, wherein a thickness of the thin glass sheet is 20 to 30 µm
